# EUROPÄISCHE PATENTSCHRIFT

(11) **EP 4 153 926 B1**
(45) Veröffentlichungstag und Bekanntmachung des Hinweises auf die Patenterteilung: **13.08.2025**
(21) Anmeldenummer: 21830653.8
(22) Anmeldetag: 06.12.2021
(51) Int. Cl.: H05B 1/02, F27D 19/00, F27B 5/04, F27B 5/12, F27B 5/13, F27B 5/18

(54) **MECHATRONISCHER VORHANG FÜR EINE PROZESSKAMMER ZUR DURCHFÜHRUNG THERMISCHER PROZESSE IN DER FERTIGUNG ELEKTRONISCHER BAUGRUPPEN**
MECATRONIC CURTAIN FOR A PROCESS CHAMBER FOR CARRYING OUT THERMAL PROCESSES IN PRODUCTION
RIDEAU MÉCATRONIQUE POUR UNE CHAMBRE DE TRAITEMENT POUR LA MISE EN OEUVRE DE PROCESSUS THERMIQUES DANS LA FABRICATION

(30) Priorität: 02.02.2021 DE 102021102393
(43) Veröffentlichungstag der Anmeldung: 29.03.2023
(73) Patentinhaber: Rehm Thermal Systems GmbH, 89143 Blaubeuren-Seissen (DE)
(72) Erfinder: WILD, Paul, 89143 Blaubeuren-Seissen (DE)
(74) Vertreter: Grünecker Patent- und Rechtsanwälte PartG mbB
(86) Internationale Anmeldenummer: PCT/EP2021/084383
(87) Internationale Veröffentlichungsnummer: WO 2022/167122

(56) Entgegenhaltungen:
- DE-C1- 3 916 178
- US-A- 5 320 274
- US-A- 5 433 368

## Beschreibung

### Gebiet der Erfindung

Die vorliegende Erfindung betrifft Vorrichtungen zur Durchführung thermischer Prozesse in der Fertigung elektronischer Baugruppen. Insbesondere betrifft die vorliegende Erfindung eine Prozesskammer gemäß dem Oberbegriff des Anspruches 1.

### Stand der Technik

Bei der Fertigung elektronischer Baugruppen finden diverse thermische Prozesse, wie beispielsweise Löten, Trocknen und Funktionstest bei hohen und tiefen Temperaturen statt. Zur Vermeidung von Oxidation oder Vereisung während des thermischen Prozesses wird die Prozesskammer mit Schutzgas, einem inerten Gas wie beispielsweise Stickstoff, kontinuierlich oder getaktet geflutet.

In typischen Anlagen zur Fertigung von elektronischen Baugruppen werden die Baugruppen automatisch von einer Prozessstation zur nächsten transportiert. Beispielsweise wird eine Leiterplatte nach ihrer Fertigung in einer Prozessstation mit einem Lötstopplack versehen und getrocknet. Danach wird die Leiterplatte in einer weiteren Prozessstation mit Lötpaste beschichtet und in einer nachfolgenden Prozessstation mit Bauelementen bestückt. Danach wird die bestückte Leiterplatte zur Reflow-Lötprozessstation und anschließend zu einer Station weitergeleitet, wo die elektronische Baugruppe mit einem Schutzlack beschichtet wird. Anschießend können Funktionstests beispielsweise bei tiefen und hohen Temperaturen durchgeführt werden. Die einzelnen Stationen sind dabei keine hermetisch abgeschlossenen Bereiche, in denen eine Schutzgasatmosphäre permanent gehalten wird. D. h. die Prozessstationen sind offen, um den Arbeitsfluss nicht zu behindern. Es bedeutet auch, dass die Schutzgasatmosphäre sich verflüchtigt und die Konzentration der Schutzgasatmosphäre am Prozessort nur aufrechterhalten werden kann, wenn ständig Schutzgas zugeführt wird.

Bei den Anlagen nach dem getaktetem und insbesondere nach dem Durchlaufprinzip müssen die Werkstücke in die Prozesskammer gebracht und herausgebracht werden. Dafür muss die Prozesskammer über entsprechende Öffnungen an und in der Kammer verfügen. Durch diese Öffnungen kommt es zum Ausströmen und damit einem Verlust des inerten Gases. Um das zu vermeiden, wird der Querschnitt dieser Öffnungen durch entsprechende Vorrichtung zum Verkleinern der Öffnung, wie beispielsweise Vorhänge, Faltbälge, Schiebeklappen etc., verkleinert.

Verwendung finden dabei beispielsweise Lamellenvorhänge mit einer Vielzahl von herabhängenden und von unten nach oben stehenden Lamellen, die aus einem mit leitfähigen Kunststoff laminierten Gewebe bestehen, das beispielsweise bis 260 °C temperaturstabil ist. Die Lamellen sind so steif, dass die von unten nach oben stehenden Lamellen nicht zusammenfallen. Die Lamellen im Einlauf der Prozesskammer sind so ausgelegt, dass sie den Öffnungsquerschnitt einer Prozesskammer auf die größte Querschnittsfläche der zuzuführenden Baugruppen verkleinern. Im Auslauf der Prozesskammer liegen die oberen und unteren Lamellen aufeinander, d.h. überlappen. Die Lamellen sind jedoch flexibel genug, dass sie sich zur Seite biegen, wenn eine Baugruppe durch die Öffnung geführt wird.

Ein Nachteil dieser Methode im Einlauf und Auslauf besteht darin, dass diese den Querschnitt nur mit einem bestimmten Abstand zu den durchlaufenden Werkstücken reduzieren, wodurch immer noch relativ viel Schutzgas entweichen kann. Wird der Abstand zu groß gewählt, entweicht zu viel Schutzgas. Wird der Abstand zu klein gewählt, können Bauteile auf der Baugruppe verschoben werden und zusätzlich entsteht zu viel Abrieb und Verschleiß und damit Verschmutzung, wenn die Bauteile die Lamellen berühren oder verbiegen.

Es wird also ein Kompromiss angestrebt zwischen Verlust von Schutzgas und dem Schutz der Baugruppen vor dem Verschieben von Komponenten und Verschleiß. Durch den "Sicherheitsabstand" zwischen der Oberfläche der Baugruppe und den Lamellen verbleibt eine Nettoöffnungsfläche, durch die Schutzgas entweichen kann, die der Differenz aus der durch die Lamellen verkleinerten Öffnungsfläche und der Baugruppenquerschnittsfläche entspricht. Passiert keine Baugruppe die Öffnung entspricht die Öffnungsfläche, durch die Schutzgas entweichen kann, der Nettoöffnungsfläche, die größer ist als die Differenzfläche. D. h., während der Durchführung des Wärmeprozesses, wenn keine Baugruppe die Öffnung passiert, entweicht mehr Schutzgas.

US 5 433 368 A offenbart eine Prozesskammer gemäß dem Oberbegriff des Anspruchs 1.

Es ist deshalb eine Aufgabe der vorliegenden Erfindung, eine Vorrichtung für eine Prozesskammer bereitzustellen, die den Querschnitt der Öffnung flexibel und effizient den Gegebenheiten (d.h. beispielsweise, keine Baugruppe passiert, großes Bauteil der Baugruppe passiert, kleines Bauteil der Baugruppe passiert) anpassen kann, so dass weniger Schutzgas entweichen kann.

### Überblick über die Erfindung

Die vorliegende Aufgabe wird erfüllt durch eine Prozesskammer gemäß Anspruch 1. Die Prozesskammer ist zur Durchführung thermischer Prozesse in der Fertigung einer elektronischen Baugruppe ausgelegt, wobei die Prozesskammer Folgendes umfasst: mindestens eine Öffnung zum Einbringen und/oder Herausnehmen der elektronischen Baugruppe und eine Einrichtung zum Zuführen eines Gases, insbesondere eines Schutzgases. Die Prozesskammer ist gekennzeichnet durch eine steuerbare Schutzeinrichtung, die an der Öffnung angeordnet ist, um ein Entweichen von Gas aus der Prozesskammer zu verringern, wobei die steuerbare Schutzeinrichtung ein erstes als integrales Teil bewegliches Element umfasst, das eine Breite zwischen der gesamten Breite der Öffnung und der Breite der elektronischen Baugruppe abdeckt; eine Einrichtung zum Erfassen von Daten betreffend die Abmessungen der elektronischen Baugruppe; und eine Steuerungseinrichtung, die die Schutzeinrichtung basierend auf den Daten betreffend die Abmessungen der elektronischen Baugruppe so steuern kann, dass, wenn die elektronische Baugruppe die Öffnung passiert, ein definierter Abstand zwischen der elektronischen Baugruppe und dem ersten beweglichen Element konstant wird.

D. h., beim Durchlaufen der Baugruppe durch die Öffnung wird der Abstand zwischen der Baugruppenoberfläche und der der Baugruppe zugewandten Kante des ersten beweglichen Elements permanent nachgeregelt, so dass der Abstand zwischen einer Kante des Elements und dem am höchsten sich über die Platine erhebenden Bauteil der Baugruppe an der aktuellen Durchlaufposition durch die Öffnung nahezu konstant klein bleibt. Im Stand der Technik werden Lamellenvorhänge verwendet, um den Öffnungsquerschnitt zu verkleinern. Die Lamellenvorhänge können jedoch nicht gesteuert werden. Die flexiblen Lamellen erlauben zwar eine Variabilität des Baugruppenquerschnitts, sind aber nicht in der Lage, den Öffnungsquerschnitt individuell je nach Baugruppe zu minimieren und bergen die Gefahr eines Kontakts mit den Bauteilen und deren Beschädigung. Als ein als integrales Teil bewegliches Element ist vorliegend z.B. ein aus einem Stück gefertigter Materialstreifen zu verstehen, es kann sich aber auch um mehrere fest oder lose miteinander verbundente streifenförmige Teile handeln, die an einer gemeinsamen Befestigung angebracht sind und gemeinsam (also nicht unabhängig voneinander) bewegt werden.

Gemäß Ausführungsformen der vorliegenden Erfindung besteht die elektronische Baugruppe aus einer Vielzahl von elektronischen Bauelementen, die auf einer Oberseite und/oder einer Unterseite einer Leiterplatte befestigt sind.

Um beidseitig bestückte Baugruppen bei der Öffnungssteuerung besser berücksichtigen zu können, kann die steuerbare Schutzeinrichtung ein zweites, als integrales Teil bewegliches Element umfassen, das eine Breite zwischen der gesamten Breite der Öffnung und der Breite der elektronischen Baugruppe abdeckt, wobei das erste bewegliche Element und das zweite bewegliche Element individuell steuerbar sind und so angeordnet sind, dass sie bei Durchtritt der elektronischen Baugruppe durch die Öffnung oberhalb und unterhalb der elektronischen Baugruppe angeordnet sind.

Um den Öffnungsquerschnitt beim Durchgang von doppelseitig bestückten Leiterplatten möglichst klein zu halten, kann die steuerbare Schutzeinrichtung (50) das zweite bewegliche Element (50A) so steuern, dass, wenn die elektronische Baugruppe (30) die Öffnung (20) passiert, ein definierter Abstand zwischen Bauelementen auf der Unterseite der elektronischen Baugruppe und dem zweiten beweglichen Element (50A) konstant gehalten werden kann.

In einer weiteren Ausführungsform umfasst die die Einrichtung zum Erfassen von Daten betreffend die Abmessungen der elektronischen Baugruppe weiterhin eine Messeinrichtung, die die Topografie bzw. dreidimensionale Struktur der elektronischen Baugruppe erfasst. Die Messeinrichtung ist vorteilhafter Weise an einer Stelle der Prozesskammer angeordnet, wo die Topographie der elektronischen Baugruppe erfasst werden kann, bevor sie die Öffnung passiert.

In bestimmten Ausführungsformen verwendet die Messeinrichtung bildgebende 2D und/oder 3D Messverfahren, und/oder optische Messverfahren, und/oder mechanische Messverfahren, und/oder akustische Messverfahren zur Erfassung der Topographie der elektronischen Baugruppe verwendet. Um ortsabhängige Höheninformationen der elektronischen Baugruppe zu bestimmen, können beispielsweise eine oder mehrere Kameras verwendet werden, um ein dreidimensionales Modell der Baugruppe zu erstellen. Alternativ dazu oder zur Unterstützung der Auswertung der Kamerabilder können die Höheninformationen auch interferometrisch mit einem Laser oder einem Array von Lasern gewonnen werden. Alternativ und unterstützend zu den vorher genannten Verfahren können auch mechanische Tastverfahren oder akustische Verfahren wie beispielsweise Erzeugen und Auswerten eines Schallfeldes zur Gewinnung von Höheninformationen verwendet werden.

Alternativ und unterstützend zu den vorher genannten Verfahren können die 2D/3D-Daten der Baugruppengeometrie aus den vorherigen Prozessen wie z.B. Baugruppenentwicklung und/oder Bestückungsprozess übernommen werden.

In einer Ausführungsform weist die Prozesskammer weiterhin eine Stelleinrichtung auf, mit der das erste und/oder das zweite bewegliche Element gleichzeitig und unabhängig voneinander in vertikaler Richtung bewegt werden kann. Somit können die beweglichen Elemente flexibel eingesetzt werden, um die Abstände zwischen der Baugruppe und dem ersten bzw. zweiten beweglichen Element konstant zu halten.

Alternativ oder in Ergänzung zur vorherigen Ausführungsform weist die Prozesskammer weiterhin eine Stelleinrichtungen auf, mit der das erste und/oder das zweite bewegliche Element gleichzeitig und unabhängig voneinander um eine horizontale Achse gedreht werden kann, so dass sich eine Drehachse an einem der Baugruppe gegenüberliegenden Ende des beweglichen Elements senkrecht zur Transportrichtung der Baugruppe befindet. Sollte beim Nachrüsten der Prozesskammer nicht genügend Platz für eine vertikale Bewegung vorhanden sein, kann damit der Abstand durch eine Schwenk-, Dreh- oder Klappbewegung konstant gehalten werde.

Die Stelleinrichtung kann dabei eine elektrische oder pneumatische Antriebseinrichtung umfassen.

In bestimmten Ausführungsformen sind die beweglichen Elemente aus Edelstahl gefertigt. Edelstahl ist ein inertes, robustes und zu wenig Korrosion neigendes Material, so dass solchermaßen ausgeführte beweglichen Elemente wartungsarm sind und die Prozesse nicht beeinflussen. Weiterhin ist Edelstahl leitfähig und ist somit in der Lage, statische Elektrizität, die sich negativ auf elektronische Baugruppen auswirken können, abzuleiten. Da Edelstahl weiterhin sehr formstabil ist, erlauben beweglichen Elemente aus Edelstahl eine präzise Positionierung relativ zur Oberfläche der elektronischen Baugruppe sowie relativ Prozesskammer.

Alternativ dazu können die beweglichen Elemente aus einem bis 240°C stabilen und leitfähigen Kunststoff gefertigt werden wie z.B. PEEK, wenn auf die Gerätekosten geachtet werden muss.

### Kurze Beschreibung der Figuren

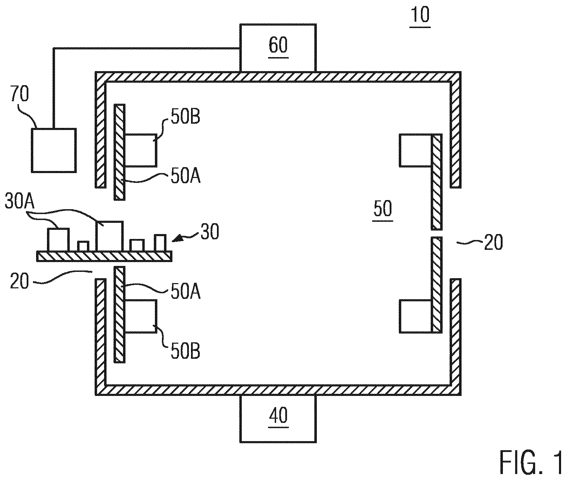

Die vorliegende Erfindung wird nun anhand der folgenden Figuren beschrieben, in denen
- Fig. 1: eine Querschnittsansicht einer Prozesskammer mit einer Schutzeinrichtung gemäß der vorliegenden Erfindung zeigt.

### Ausführliche Beschreibung

Die vorliegende Erfindung betrifft eine Prozesskammer zur Durchführung thermischer Prozesse in der Fertigung elektronischer Baugruppen. Bei der Fertigung elektronischer Baugruppen sind die einzelnen Prozessschritte wie beispielsweise Beschichten, Bestückten, Löten, Lackieren, Testen etc. nicht hermetisch voneinander getrennt. Die elektronischen Baugruppen werden zwischen den einzelnen Verarbeitungsschritten auf einer Transporteinrichtung zwischen den Prozessstationen/Prozesskammern transportiert. Die Prozesskammern weisen Öffnungen auf, um die elektronischen Baugruppen in die und aus der Kammer zu bringen. Der Fertigungsprozess findet also in einer offenen Umgebung statt, wodurch der Arbeitsfluss erleichtert wird. Allerdings finden die thermischen Prozesse unter einer Schutzgasatmosphäre statt, um Oxidation zu vermeiden. Dazu wird durch lokales Zuführen von Schutzgas eine lokale Schutzgasatmosphäre geschaffen. Durch den offenen Charakter der Prozessabläufe handelt es sich dabei um ein dynamisches Gleichgewicht für die Schutzgaskonzentration am Prozessort, bei dem ständig lokal so viel Schutzgas zugegeben wird, dass der Abfluss durch die Öffnungen kompensiert wird. Je kleiner die Öffnungen desto weniger Schutzgas muss nachgeführt werden, um eine bestimmte Konzentration am Prozessort aufrecht zu erhalten. Die vorliegende Erfindung erfolgte, um den offenen Charakter der Prozessabläufe beizubehalten, und um die notwendigen Öffnungen möglichst klein zu halten. Dadurch wird der Verbrauch an Schutzgas verringert. Weiterhin entsteht dadurch eine stabilere Prozessumgebung und die Prozessergebnisse sind reproduzierbarer.

Um den Öffnungsquerschnitt um das Werkstück baugruppenabhängig zu reduzieren und damit den Verlust des inerten Schutzgases zu senken, wird der Öffnungsquerschnitt aktiv an die Topographie eines Werkstücks angepasst. Dazu kann zuerst die Topografie des Werkstücks mit Hilfe von 2D und/oder 3D bildgebenden, optischen, mechanischen und/oder akustischen Messverfahren bestimmt werden. Alternativ und/oder unterstützend zu den vorher genannten Verfahren können die 2D/3D-Daten der Baugruppengeometrie aus den vorherigen Prozessen wie z.B. Baugruppenentwicklung und/oder Bestückungsprozess übernommen werden. Auf Basis dieser Daten kann ein pneumatisch, elektrisch oder mechanisch angesteuertes bewegliches Element einen Abstand zwischen einer Kante des beweglichen Elements und der Baugruppenoberfläche zu minimieren, sodass der Öffnungsquerschnitt abhängig von der Topografie des Werkstückes in der Durchlaufrichtung minimiert wird.

Fig. 1 zeigt schematisch eine Querschnittsansicht einer Prozesskammer gemäß der vorliegenden Erfindung. Im Querschnitt von Figur 1 bezeichnet des Bezugszeichen 10 eine Prozesskammer, das Bezugszeichen 20 eine Öffnung, das Bezugszeichen 30 eine elektronische Baugruppe, das Bezugszeichen 30A Bauelemente der Baugruppe, das Bezugszeichen 40 eine Einrichtung zum Zuführen eines Schutzgases, das Bezugszeichen 50 eine steuerbare Schutzeinrichtung, das Bezugszeichen 50A ein bewegliches Element, das Bezugszeichen 50B eine Stelleinrichtung, das Bezugszeichen 60 eine Steuerungseinrichtung und das Bezugszeichen 70 eine Messeinrichtung. In Figur 1 ist die Prozesskammer 10 mit zwei Öffnungen 20 dargestellt, die zum Einbringen bzw. Herausnehmen der elektronischen Baugruppe 30 vorgesehen sind. Das bewegliche Element 50A ist als erstes und zweites bewegliches Element dargestellt, die jeweils einen oberen Abschnitt bzw. unteren Abschnitt der Öffnung abdecken.

In der in Figur 1 dargestellten Anordnung wird eine Baugruppe 30 in die Prozesskammer 10 eingeführt. Die Darstellung von Figur 1 zeigt einen Zustand zu einem Zeitpunkt t₁, an dem die Baugruppe 30 die Öffnung 20 des Einlasses passiert. Zu diesem Zeitpunkt t₁ hat die Steuerungseinrichtung 60 die Stelleinrichtung 50B der Schutzeinrichtung 50 bereits veranlasst, das erste und zweite bewegliche Element 50A der Schutzeinrichtung 50 so weit zurückzuziehen, dass die elektronische Baugruppe 30 unter Berücksichtigung der Höhe des aktuell am Ort der Schutzeinrichtung stehenden Bauelementes 30A durch die Öffnung passt. Dabei wird ein Sicherheitsabstand zwischen dem beweglichen Element 50A und der Oberfläche des Bauelements 30A eingehalten.

Um einerseits eine effektive Verringerung von Gasaustritt aus der Prozesskammer zu erzielen, aber andererseits einen geringen baulichen Aufwand zu betreiben, ist es vorteilhaft die beweglichen Elemente mit einer Breite auszubilden, die größer ist als die Breite der einzelnen Bauelemente auf der Baugruppe. So wird zwar eine Spaltbreite nur zwischen dem am höchsten sich erhebenden Bauteil und der Kante des als integrales Teil beweglichen Elements konstant klein, d.h. auf einen einstellbaren minimalen Wert gehalten, aber es wird auch die Zahl der beweglichen Elemente reduziert, wobei bevorzugt nur ein einziges bewegliches Element zu einer Seite der Baugruppe vorhanden ist. Es ist besonders vorteilhaft, das bewegliche Element in einer Breite, die der Breite des Spalts für den Durchtritt der Baugruppen entspricht, auszugestalten. Andererseits könnte die Breite des beweglichen Elements der Breite der Baugruppe, also in etwa der Breite einer Leiterplatte, auf der die Bauelemente angeordnet sind, entsprechen, oder größer sein, bis hin zur Breite des Spalts. In letzterem Fall ist vorteilhafterweise eine weitere Anordnung zur Verringerung des Austritts von Gas vorhanden, z.B. eine oder mehrere feststehende, oder auch seitlich bewegliche Plattenelemente, die an die beweglichen Elemente seitlich angrenzen.

Die beweglichen Elemente können jeweils einzelne, aus einem Materialstück gefertigte streifenförmige Elemente sein. Sie können allerdings auch aus mehreren Teilstücken zusammengesetzt sein, die fest oder auch lose miteinander verbunden sind. In einer Ausführungsform besitzen die beweglichen Elemente eine gerade Kante an der der jeweiligen Baugruppe zugewandten Seite. Alternativ kann diese Kante auch bereits einer typischen Topographie der Baugruppen angepasst sein.

Obwohl die Schutzeinrichtung 50 bis jetzt so dargestellt wurde, dass sich das bewegliche Elemente in vertikaler Richtung bewegt (d.h. zurückzuzieht), kann das bewegliche Element und die entsprechenden Stelleinrichtungen 50B so ausgebildet sein, dass das bewegliche Element um eine horizontale Achse gedreht werden kann, so dass sich eine Drehachse an einem der Baugruppe gegenüberliegenden Ende des beweglichen Elements senkrecht zur Transportrichtung der Baugruppe befindet. Dies wird in Fig. 1 schematisch an der Auslassöffnung gezeigt. Dort zeigt Fig. 1 eine Drehachse DA, die senkrecht zur Bildebene und zur Transportrichtung der Baugruppe liegt. Fig. 1 zeigt auch einen Pfeil P1, der die Drehrichtung des beweglichen Elements andeutet. An der Einlassöffnung zeigt ein Pfeil P2 die alternative vertikale Bewegungsrichtung an. Beide Bewegungsmechanismen können einzeln oder in Kombination in der Prozesskammer implementiert sein.

In der in Figur 1 dargestellten Anordnung passiert zum Zeitpunkt t₁ keine elektronische Baugruppe die Öffnung am Ausgang der Prozesskammer 10. Entsprechend sind das erste und zweite bewegliche Element 50 A so positioniert, dass sie die Prozesskammer 10 nahezu verschließen, bzw. eine Öffnung freilassen, die einem Sicherheitsabstand zwischen dem ersten und zweiten beweglichen Element 50A zueinander bzw. zu angrenzenden Strukturen entsprechen.

Zu einem späteren Zeitpunkt t₂ (nicht gezeigt), zu dem sich ein nachfolgendes Bauelement 30A am Ort der Schutzeinrichtung 50 befindet, veranlasst die Steuerungseinrichtung 60 die Stelleinrichtung 50B der Schutzeinrichtung 50, die Position des ersten und zweiten beweglichen Elements 50A der Schutzeinrichtung 50 der Höhe des nachfolgenden Bauelements 30A anzupassen. Dabei können das erste und zweite bewegliche Element gleichzeitig und unabhängig voneinander bewegt werden, so dass das zweite bewegliche Element an der Unterseite der Baugruppe dem dortigen Höhenprofil folgen kann.

Die Höheninformationen der Bauelemente 30A kann beispielsweise mit einer Messeinrichtung 70 zu einem vorangehenden Zeitpunkt t₀ bestimmt werden (nicht gezeigt), bevor die elektronische Baugruppe 30 die Öffnung 20 passiert. Beispielsweise kann über bildgebende Verfahren, beispielsweise mittels Kamera, ein 3D Modell der elektronischen Baugruppe 30 erstellt werden, aus dem die Höhendaten der Bauelemente 30A ausgelesen werden können. Alternativ kann die Lage- und Höheninformation aus Bauteildaten, die sich aus der Bestückung der Leiterplatte mit den Bauteilen ergeben, ohne die Notwendigkeit von Messungen erhalten werden. Es werden dabei Datenfiles generiert, die an die Steuerungseinrichtungen übergeben werden. Zusammen mit Position und Geschwindigkeitsdaten der elektronischen Baugruppe 30 relativ zu Prozesskammer 10 kann die Steuerungseinrichtungen 60 berechnen, zu welcher Zeit ein bestimmtes Bauelement mit einer bestimmten Höhe an der Stelle der Schutzeinrichtung 60 die Öffnung 20 passiert. Entsprechend kann die Steuerungseinrichtung 60 die Stelleinrichtung 50B ansteuern, um das bewegliche Element 50A entsprechend der Höhe des Bauteils 30A zu positionieren.

Alternativ oder in Kombination kann die Höheninformation der Bauelemente 30A mit einem mechanischen Taster oder/und interferonmetrischen Sensoren unmittelbar am Eingang der Öffnung 20 ermittelt werden.

Vorzugsweise sind die beweglichen Elemente 50A (d.h. das erste bewegliche Element und das optionale zweite bewegliche Element) aus Edelstahl gefertigt. Dadurch erhält man haltbare, formstabile und leitfähige bewegliche Elemente. Korrosion und Abrieb sind gering, so dass weniger Wartung erforderlich ist. Weiterhin sorgt die Leitfähigkeit für eine Ableitung von statischer Elektrizität, die beispielsweise beim Transport auf der elektronischen Baugruppe entsteht. Eine bessere Ableitung von statischer Elektrizität lässt sich beispielsweise durch weiche leitfähige Bürsten am Ende der individuell steuerbaren beweglichen Elemente erreichen, die statische Ladungen ableiten können. Da bewegliche Elemente aus Edelstahl formstabil sind und sehr präzise gefertigt werden können, können Sicherheitsabstände zu Bauelementen oder anderen Teilen der Prozesskammer minimiert werden, so dass die Nettoöffnung, durch die Schutzgas entweichen kann, minimiert werden kann. Unter Nettoöffnung wird eine Nettoöffnungsfläche verstanden, durch die Schutzgas entweichen kann. Die Nettoöffnungsfläche entspricht der Differenz zwischen der durch die individuell steuerbaren beweglichen Elemente verkleinerte Öffnungsfläche und der Baugruppenquerschnittsfläche.

Werden geringere Anforderungen an Präzision und Minimierung von Verbrauchsmaterial und Wartung gestellt, kann auch ein leitfähiger temperaturstabiler Kunststoff als Material für die beweglichen Elemente verwendet werden, wodurch die Herstellungskosten für die Prozesskammer verringert werden können.

Als Stelleinrichtung werden vorzugsweise elektrische, elektromechanische oder pneumatische Antriebseinrichtungen verwendet. Beispielsweise könnte ein Schrittmotor mit definierter Schrittweite, ein pneumatischer Kolben mit Positionserfassung, ein Elektromotor mit Positionserfassung des beweglichen Elements, etc. verwendet werden.

Die Steuerungseinrichtung 60 kann mit der Messeinrichtung 70 und der Stelleinrichtung 50B drahtlos oder drahtgebunden kommunizieren.

CAD Daten bzw. 2D/3D Daten der Baugruppen können beispielsweise drahtlos an die Messeinrichtung 70 oder die Steuerungseinrichtung 60 eingegeben werden.

## Patentansprüche

1. Prozesskammer (10) zur Durchführung thermischer Prozesse in der Fertigung einer elektronischen Baugruppe (30), die Folgendes umfasst:
mindestens eine Öffnung (20) zum Einbringen und/oder Herausnehmen der elektronischen Baugruppe (30);
eine Einrichtung (40) zum Zuführen eines Gases;
eine steuerbare Schutzeinrichtung (50), die an der Öffnung (20) angeordnet ist, um ein Entweichen von Gas aus der Prozesskammer zu verringern, wobei die steuerbare Schutzeinrichtung (50) ein erstes, als integrales Stück bewegliches Element (50A) umfasst, das eine Breite zwischen der gesamten Breite der Öffnung und der Breite der elektronischen Baugruppe abdeckt;
**gekennzeichnet durch**
eine Einrichtung zum Erfassen von Daten betreffend die Abmessungen der elektronischen Baugruppe (30); und
eine Steuerungseinrichtung (60), die die Schutzeinrichtung (50) basierend auf den Daten betreffend die Abmessungen der elektronischen Baugruppe (30) so steuern kann, dass, wenn die elektronische Baugruppe (30) die Öffnung (20) passiert, ein definierter Abstand zwischen der elektronischen Baugruppe und dem ersten beweglichen Element (50A) konstant gehalten wird.

2. Prozesskammer (10) nach Anspruch 1, wobei die steuerbare Schutzeinrichtung ein zweites bewegliches Element (50A) umfasst, das eine Breite zwischen der gesamten Breite der Öffnung und einer Breite der elektronischen Baugruppe abdeckt, wobei das erste bewegliche Element und das zweite bewegliche Element jeweils als integrales Stück beweglich sind und individuell steuerbar sind und so angeordnet sind, dass sie bei Durchtritt der elektronischen Baugruppen durch die Öffnung oberhalb und unterhalb der elektronischen Baugruppen angeordnet sind.

3. Prozesskammer (10) nach Anspruch 2, wobei die steuerbare Schutzeinrichtung (50) das zweite bewegliche Element (50A) so steuern kann, dass, wenn die elektronische Baugruppe (30) die Öffnung (20) passiert, ein definierter Abstand zwischen Bauelementen auf der Unterseite der elektronischen Baugruppe und dem zweiten beweglichen Element (50A) konstant gehalten werden kann.

4. Prozesskammer (10) nach einem der vorherigen Ansprüche, wobei die Einrichtung zum Erfassen von Daten betreffend die Abmessungen der elektronischen Baugruppe (30) eine Messeinrichtung (70) umfasst, die die Topografie bzw. dreidimensionale Struktur der elektronischen Baugruppe erfasst.

5. Prozesskammer (10) nach Anspruch 4, wobei die Messeinrichtung (70) bildgebende 2D und/oder 3D Messverfahren, und/oder optische Messverfahren, und/oder mechanische Messverfahren, und/oder akustische Messverfahren zur Erfassung der Topographie der elektronischen Baugruppe verwendet.

6. Prozesskammer (10) nach einem der vorherigen Ansprüche, wobei die Einrichtung zum Erfassen von Daten ausgelegt ist, vorhandene 2D und/oder 3D Daten der Baugruppen zu übernehmen.

7. Prozesskammer (10) nach einem der vorherigen Ansprüche, die weiterhin eine Stelleinrichtung (50B) aufweist, mit der das erste und/oder das zweite bewegliche Element gleichzeitig und unabhängig voneinander in vertikaler Richtung bewegt werden kann.

8. Prozesskammer (10) nach einem der vorherigen Ansprüche, die weiterhin eine Stelleinrichtung (50B) aufweist, mit der das erste und/oder das zweite bewegliche Element gleichzeitig und unabhängig voneinander um eine horizontale Achse gedreht werden kann, so dass sich eine Drehachse (DA) an einem der Baugruppe gegenüberliegenden Ende des beweglichen Elements senkrecht zur Transportrichtung der Baugruppe befindet.

9. Prozesskammer (10) nach Anspruch 7 oder 8, wobei die Stelleinrichtung eine elektrische oder pneumatische Antriebseinrichtung umfasst.

10. Prozesskammer (10) nach einem der vorherigen Ansprüche, wobei das erste und/oder das zweite bewegliche Element aus Edelstahl gefertigt ist.

11. Prozesskammer (10) nach einem der vorherigen Ansprüche, wobei das erste und/oder das zweite bewegliche Element aus einem bis 280°C stabilen und leitfähigen Kunststoff gefertigt sind.

## Claims

1. Process chamber (10) for carrying out thermal processes in the manufacture
of an electronic assembly (30), comprising: at least one opening (20) for inserting and/or removing the electronic assembly (30);
a device (40) for supplying a gas;
a controllable protective device (50) which is arranged at the opening (20) in order to reduce the escape of gas from the process chamber, wherein the controllable protective device (50) comprises a first element (50A) which is movable as an integral piece and which covers a width between the entire width of the opening and the width of the electronic assembly;
**characterized by**
means for detecting data relating to the dimensions of the electronic assembly (30); and
a control device (60) that can control the protective device (50) based on the data relating to the dimensions of the electronic assembly (30) in such a way that, when the electronic assembly (30) passes through the opening (20), a defined distance between the electronic assembly and the first movable element (50A) is kept constant.

2. Process chamber (10) according to claim 1, wherein the controllable protective device comprises a second movable element (50A) covering a width between the entire width of the opening and a width of the electronic assembly, wherein the first movable element and the second movable element are each movable as an integral piece and are individually controllable and are arranged that they are arranged above and below the electronic assemblies when the electronic assemblies pass through the opening.

3. Process chamber (10) according to claim 2, wherein the controllable protective device (50) can control the second movable element (50A) such that, when the electronic assembly (30) passes through the opening (20), a defined distance between components on the underside of the electronic assembly and the second movable element (50A) can be maintained constant.

4. Process chamber (10) according to one of the previous claims, wherein the device for detecting data relating to the dimensions of the electronic assembly (30) comprises a measuring device (70) which detects the topography or three-dimensional structure of the electronic assembly.

5. Process chamber (10) according to claim 4, wherein the measuring device (70) uses 2D and/or 3D imaging measurement methods and/or optical measurement methods and/or mechanical measurement methods and/or acoustic measurement methods to detect the topography of the electronic assembly.

6. Process chamber (10) according to one of the previous claims, wherein the device for capturing data is designed to transfer existing 2D and/or 3D data of the assemblies.

7. Process chamber (10) according to one of the previous claims, which further comprises an actuating device (50B) with which the first and/or the second movable element can be moved simultaneously and independently of one another in the vertical direction.

8. Process chamber (10) according to one of the previous claims, which further comprises an actuating device (50B) with which the first and/or second movable element can be rotated simultaneously and independently of one another about a horizontal axis, so that an axis of rotation (DA) at an end of the movable element opposite the assembly is perpendicular to the transport direction of the assembly.

9. Process chamber (10) according to claim 7 or 8, wherein the actuating device comprises an electric or pneumatic drive device.

10. Process chamber (10) according to one of the previous claims, wherein the first and/or second movable element is made of stainless steel.

11. Process chamber (10) according to one of the previous claims, wherein the first and/or second movable element are made of a plastic that is stable and conductive up to 280°C.

## Revendications

1. Chambre de procédé (10) permettant de mettre en œuvre des procédés thermiques dans la fabrication d'un module électronique (30), comprenant :
au moins un orifice (20) permettant l'insertion et/ou le retrait du module électronique (30) ;
un dispositif (40) permettant d'alimenter un gaz ;
un dispositif de protection pouvant être commandé (50), qui est agencé au niveau de l'orifice (20), afin de réduire la fuite du gaz hors de la chambre de procédé, dans laquelle le dispositif de protection pouvant être commandé (50) comprend un premier élément (50A) mobile sous forme de partie intégrante et couvrant une largeur comprise entre la largeur totale de l'orifice et la largeur du module électronique ;
**caractérisée par**
un dispositif permettant d'enregistrer des données relatives aux dimensions de l'module électronique (30) ; et
un dispositif de commande (60) qui peut commander le dispositif de protection (50) en se basant sur les données relatives aux dimensions du module électronique (30) de telle sorte que, lorsque le module électronique (30) traverse l'orifice (20), une distance définie entre le module électronique et le premier élément mobile (50A) est maintenue constante.

2. Chambre de procédé (10) selon la revendication 1, dans laquelle le dispositif de protection pouvant être commandé comprend un second élément mobile (50A) qui couvre une largeur comprise entre la largeur totale de l'orifice et une largeur du module électronique, dans laquelle le premier élément mobile et le second élément mobile sont respectivement mobiles sous forme de partie intégrante et peuvent être commandés individuellement et sont agencés de manière à être agencés au-dessus et au-dessous des modules électroniques lors du passage des modules électroniques à travers l'orifice.

3. Chambre de procédé (10) selon la revendication 2, dans laquelle le dispositif de protection pouvant être commandé (50) peut commander le second élément mobile (50A) de sorte que, lorsque le module électronique (30) traverse l'orifice (20), une distance définie entre les éléments sur la face inférieure du module électronique et le second élément mobile (50A) peut être maintenue constante.

4. Chambre de procédé (10) selon l'une quelconque des revendications précédentes, dans laquelle le dispositif permettant d'enregistrer des données relatives aux dimensions du module électronique (30) comprend un dispositif de mesure (70) qui enregistre la topographie ou la structure tridimensionnelle du module électronique.

5. Chambre de procédé (10) selon la revendication 4, dans laquelle le dispositif de mesure (70) utilise des procédés de mesure d'imagerie 2D et/ou 3D, et/ou des procédés de mesure optiques, et/ou des procédés de mesure mécaniques, et/ou des procédés de mesure acoustiques, pour détecter la topographie du module électronique.

6. Chambre de procédé (10) selon l'une quelconque des revendications précédentes, dans laquelle le dispositif permettant d'enregistrer des données est conçu pour prendre en charge des données 2D et/ou 3D existantes des modules.

7. Chambre de procédé (10) selon l'une quelconque des revendications précédentes, présentant en outre un dispositif de réglage (50B) grâce auquel le premier et/ou le second élément mobile peu(ven)t être déplacé(s) simultanément et indépendamment l'un de l'autre dans la direction verticale.

8. Chambre de procédé (10) selon l'une quelconque des revendications précédentes, présentant en outre un dispositif de réglage (50B) grâce auquel le premier et/ou le second élément mobile peu(ven)t être pivoté(s) simultanément et indépendamment l'un de l'autre autour d'un axe horizontal, de sorte qu'un axe de rotation (DA) se trouve à une extrémité de l'élément mobile opposée au module, perpendiculairement à la direction de transport du module.

9. Chambre de procédé (10) selon la revendication 7 ou 8, dans laquelle le dispositif de réglage comprend un dispositif d'entraînement électrique ou pneumatique.

10. Chambre de procédé (10) selon l'une quelconque des revendications précédentes, dans laquelle le premier et/ou le second élément mobile est/sont fabriqué(s) en acier inoxydable.

11. Chambre de procédé (10) selon l'une quelconque des revendications précédentes, dans laquelle le premier et/ou le second élément mobile est/sont fabriqué(s) à partir d'une matière plastique conductrice et stable jusqu'à 280°C.
